# EUROPEAN PATENT SPECIFICATION

(11) **EP 1 595 977 B1**
(45) Date of publication and mention of the grant of the patent: **21.07.2010**
(21) Application number: 05252911.2
(22) Date of filing: 11.05.2005
(51) Int. Cl.: C23C 30/00, C23C 14/06, F01D 5/28

(54) **Superalloy article having corrosion resistant coating thereon**
Werkstück aus einer Superlegierung mit einer korrosionsbeständigen Beschichtung
Pièce en superalliage ayant un revêtement résistant à la corrosion

(30) Priority: 12.05.2004 US 843966
(43) Date of publication of application: 16.11.2005
(73) Proprietor: GENERAL ELECTRIC COMPANY, Schenectady, NY 12345 (US)
(72) Inventor: Hazel, Brian Thomas, West Chester, Ohio 45069 (US)
(74) Representative: Bedford, Grant Richard

(56) References cited:
- EP-A- 0 264 654
- EP-A- 1 029 115
- EP-A- 1 160 350
- US-A- 5 683 226
- US-A1- 2002 132 131
- US-A1- 2002 189 722

## Description

The invention generally relates to a superalloy article having an oxidation and corrosion resistant coating thereon. More particularly, the invention relates to a superalloy article, such as one employed in the turbine and compressor sections of a gas turbine engine and exposed to oxidizing and corrosive environments at moderately elevated service temperatures, having an oxidation and corrosion resistant coating thereon

Higher operating temperatures for gas turbine engines are continuously sought in order to increase efficiency. However, as operating temperatures increase, the high temperature durability of the components within the engine must correspondingly increase.

Significant advances in high temperature capabilities have been achieved through the formulation of nickel- and cobalt-based superalloys. For example, some gas turbine engine components may be made of high strength directionally solidified or single crystal nickel-based superalloys. These components are cast with specific external features to do useful work with the core engine flow and often contain internal cooling details and through-holes to provide external film cooling to reduce airfoil temperatures.

However, the components of a gas turbine engine are often simultaneously exposed to an oxidative/corrosive environment and elevated temperatures. Corrosion may arise from corrosive species, such as salt ingested into the gas turbine with its air supply, as well as corrosive species produced in the combustor when the ingested air is mixed with fuel and ignited. In many case, the loads applied to the components also accelerate the corrosive attack.

When exposed to the demanding conditions of gas turbine engine operation, particularly in the turbine section, the base alloys alone may be susceptible to the afore-described damage by oxidation and corrosion attack and may not retain adequate mechanical properties. Thus, some components often are protected by environmental or overlay coatings, which inhibit environmental damage.

Different types of coatings providing protection on various components may be employed depending upon factors, such as whether the application involves exposure to air or combustion gas, and temperature exposure. One type of coating described in U.S. Patent 6,616,978 employs a multilayer arrangement of one or more oxide-based layers and a phosphate layer applied thereon as a sealant. Other types of coatings include those described in U.S. Patents 3,248,249; 3,248,250; 3,248, 251; and commonly assigned U.S. serial number 10/199,185.

Inhibiting the potential corrosion of turbine disks, rotors, seal elements or other components exposed to similar temperature and bleed gas environments is of particular interest because such corrosion may occur as a result of deposition of solid particles that are supplied by ingestion of sea salt, fly ash, concrete dust, etc. and travel through the cooling air circuits of the engine containing metal sulfates, sulfites, carbonates, chlorides and oxides or other reducing agents. Alkaline sulfate deposits resulting from ingested dirt and sulfur in the combustion gas are a main source of corrosion, but other elements in the aggressive combustion and bleed gas environment may also accelerate the corrosion. Similarly, reaction of these particles with the base metal alloy at high temperatures may form reduced metal sulfides and subsequent attack and pitting of the base alloy covered by air-impermeable fused solid particles. Such damage may lead to premature removal and replacement of the disks and seal elements unless the damage is reduced or repaired.

Turbine and compressor disks and seal elements for use at the highest operating temperatures are made of nickel-base superalloys selected for good elevated temperature toughness and fatigue resistance. These superalloys are selected for their mechanical properties. They have adequate resistance to oxidation and corrosion damage, but that resistance may not be sufficient to protect them at the operating temperatures now being reached. Disks and other rotor components made from newer generation alloys may also contain lower levels of aluminum and chromium, and may be more susceptible to corrosion attack.

Thus, there is a continuing need for new and improved environmental or overlay coatings, particularly oxidation and corrosion resistant coatings to protect components of the turbine and compressor sections of a gas turbine engine, such as disks, seal elements and other rotor components that have historically not been coated to protect them against oxidation and corrosion. A number of oxidation-resistant and corrosion-resistant coatings have been considered for use on turbine blades. Overlay coatings for turbine engine rotor components, where a base metal substrate is coated with a metal nitride, are described in EP-A-1,160,350; EP-A-0,264,654; US-A-2002/132131; US-A-5,683,226; and EP-A-1,029,115. These turbine blade coatings are generally too thick and heavy for use on disks and seal elements, and also may adversely affect the fatigue life of the disks and seal elements. There remains a need for protecting disks, seal elements, and other rotor components against oxidation and corrosion as their operating temperatures increase. Embodiments of the invention fulfill this need and others.

It has been determined that application of an aluminum nitride overlay coating to turbine disks, rotors or other components exposed to similar temperature and environment provides an effective environmentally protective coating toward ingested salts and sulfates. The overlay coating typically has good adhesion, minimal diffusion into the base substrate and limited or no debit on low cycle fatigue properties. During engine operation and/or high temperature exposure, the overlay coating may oxidize to form a stable metal oxide on the surface of the coating providing further improved oxidation and corrosion resistance.

Accordingly, in one embodiment of the invention, a turbine engine rotor disk or seal element consists of:
a base metal substrate;
an oxidation and corrosion resistant overlay coating applied directly on the base metal substrate of the turbine engine rotor disk or seal element to a thickness of 2-4 µm, the coating comprising aluminum nitride; and
an oxide metal layer over the overlay coating, being an oxide of the metal of the overlay coating.

In accordance with a further embodiment of the invention, a method of protecting a turbine engine rotor disk or seal element from oxidation and corrosion comprises:
providing a turbine engine rotor disk or seal element having a base metal substrate;
applying an oxidation and corrosion resistant overlay coating to a thickness of 2-4 µm directly on the base metal substrate, the overlay coating being aluminum nitride; and
exposing the applied overlay coating to elevated temperature in air to form over the overlay coating an oxide of the metal of the overlayer coating.

Other features and advantages will be apparent from the following more detailed description, taken in conjunction with the accompanying drawings, which illustrate by way of example the principles of the invention, and in which:
Figure 1 shows a portion of the turbine section of a gas turbine engine component; and
Figure 2 shows an overlay coating deposited on a rotor component, in accordance with an embodiment of the invention.

Embodiments of the invention provide a method for forming a protective coating on a turbine engine rotor component used at a moderately elevated service operating temperature. The approach allows the mechanical performance of the rotor component to be optimized using the best available alloy, according to embodiments of the invention. The selected alloy is protected against environmental damage by forming an aluminum nitride protective coating on the rotor component. The protective coating is highly adherent, does not adversely affect the properties of the underlying base metal, and is thin so that it does not significantly alter the dimensions of the component to which it is applied. The protective coating can also be readily reconditioned and repaired if necessary.

Embodiments of the invention are generally applicable to components or portions thereof that operate within moderately elevated service operating temperatures, such as between about 1000°F (538°C) to about 1500°F (816°C). Thus, the superalloy article to be coated may generally include components within the turbine and compressor sections of a gas turbine engine, including under the platform portion of the turbine blades. For example, a turbine engine rotor component may be of any type. However, the present approach is particularly useful when used to protect rotor components or portions thereof that experience that afore-described operating temperature. Examples of particular interest may include all or part of a turbine or compressor disk or seal element. It may not be necessary to coat the entire rotor component in many cases. For instance, the mid-to-outer portion of the hub of the turbine disk may be coated, while the bore region, inner portion of the hub, and blade slot may or may not be coated.

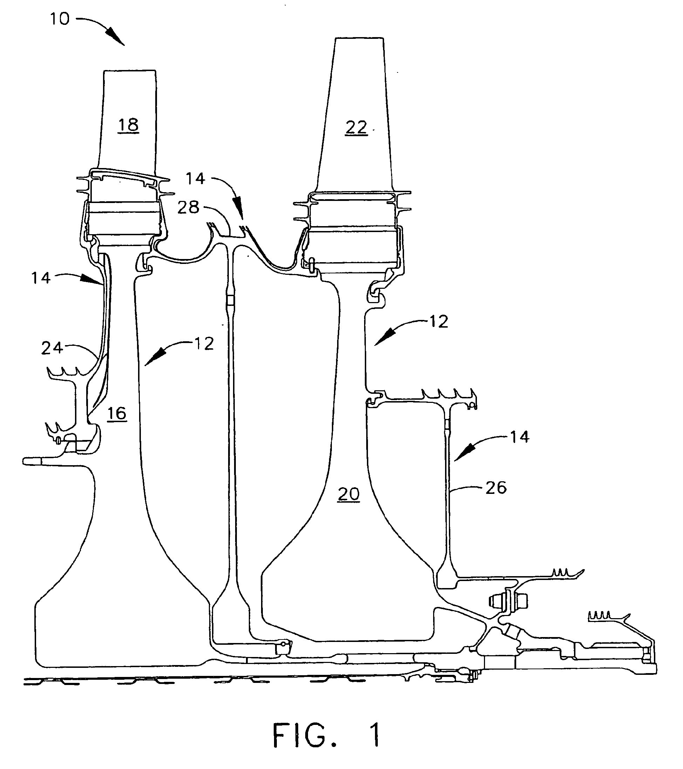

An example of a turbine engine rotor component 10 is shown in Fig. 1. The rotor component 10 may be of any type, such as a turbine disk 12 or seal element 14. Shown in Fig. 1 is a stage 1 turbine disk 16 and a stage 1 turbine blade 18 mounted to turbine disk 16. Also shown therein is a stage 2 turbine disk 20, a stage 2 turbine blade 22 mounted to the turbine disk 20, a forward seal 24, an aft seal 26 and an interstage seal 28. Any or all of the turbine disks or seal elements may be coated with coating 30 by the approach herein described, depending upon whether corrosion is anticipated or observed. In a typical case, only a portion of the selected rotor component 10 is coated. The turbine blades 18 and 22 are typically not coated by the embodiments herein, however, the sections underneath the platforms may be coated with coating 30.

The afore-described superalloy article to be coated may be made of any suitable material, including a superalloy of Ni and Co and combinations thereof. Often, this base metal may be a powder processed and hot isothermally forged Ni-base superalloy. Ni-base superalloys are advantageously strengthened by the precipitation of gamma prime or a related phase. Examples of Ni-base superalloys of interest include those known as René 88 and René 88DT, having a composition by weight percent, respectively, of i) 13Co, 16Cr, 4Mo, 3.7Ti, 2.1AI, 4W, 0.7Nb, 0.015B, 0.03r, and 0.03C, balance Ni and minor impurities and ii) 13Co, 16Cr, 4Mo, 4W, 2AI, 3.6Ti, 0.7Nb, 0.05Zr, 0.05Cr, 0.015B, balance Ni and minor impurities.

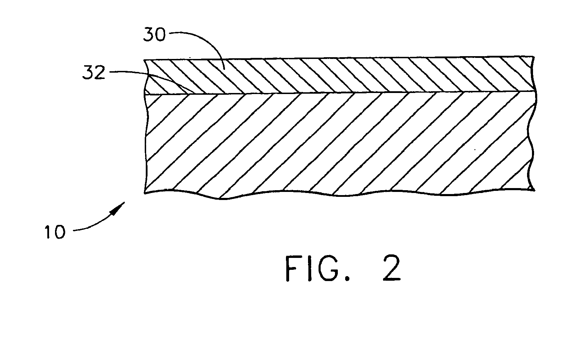

In accordance with embodiments of the invention, coating 30 may be deposited on the afore-described superalloy substrate. For example, coating 30 as shown in Fig. 2 may be deposited upon the surfaces 32 of portions of rotor component 10 that experience a service operating temperature between about 1000°F (538°C) to about 1500°F (816°C). Coating 30 may not be necessary on portions, such as the portions of the turbine disk 12 near the center bore, whose service operating temperature is less than about 1000°F (538°C) because the oxidation and corrosion resistance of the materials of construction should provide sufficient resistance. Similarly, more complex and layered protective coatings, such as thicker aluminide diffusion coatings, overlay coatings and possible thermal barrier coatings, are often used on those portions of the turbine engine components whose service operating temperature is greater than about 1500°F (816°C). Thus, typically, a ceramic, thermal barrier coating (TBC) is not employed over the coatings 30 described herein.

Coating 30 may be deposited by any suitable deposition methods known in the art, including but not limited to conventional chemical vapor deposition (CVD), metal organic chemical vapor deposition (MO-CVD), physical vapor deposition (PVD), cathodic arc deposition, reactive sputtering and molecular beam epitaxy. As an example of one of the afore-described deposition techniques, MO-CVD typically involves a vapor coating apparatus including a chamber in which an article to be coated (in the present case, rotor component 10 for example). Masking techniques may be employed to cover any portions of the component 10, which are not desired to be coated by coating 30. The chamber may then be heated to a desired deposition temperature with use of appropriate heaters, such as resistance heaters. This temperature is dependent upon the base metal material, as well as the composition of coating 30 to be deposited. Typically, the temperature is less than the temperature experience during engine service. Care should also be employed to avoid any adverse effects on the underlying base metal material. Reagents that produce a deposition vapor may be placed in a heated reagent source chamber. As known in the art, the reagents include organic chemical compounds that contain the elements to be deposited. A vapor is thus produced that contains and transports the constituents needed to form coating 30.

Deposition of AIN by cathodic arc: As an example of another one of the afore-described deposition techniques for use with embodiments of the invention, a cathodic arc apparatus typically involves a vacuum chamber which includes an anode, a power supply, and a cathode target assembly connected to the power supply. The cathode target assembly includes a cathode target of the metal desired in the metal nitride, metal carbide or metal carbonitride coating and a target holder. The deposition chamber is first evacuated to a pressure of less than 5 x 10⁻³ Pa. An arc is generated using an electronic trigger and an external magnetic field sustained the arc on the face of the cathode target generating an intense source of highly ionized plasma ideal for depositing materials onto substrate surfaces. A bias voltage is established between the cathode target and the component requiring coating to drive deposition of the target composition. By introducing controlled gases to the ionized plasma cloud, a compound of the target and introduced gas can be deposited on the substrate. For example, a pure aluminum target can be ionized and nitrogen introduced into the chamber to a pressure of 6 x 10⁻² Pa. The substrates were biased using a RF source at -40 V and the arc current during deposition was maintained at 50 A. This process generates deposition rates on the order of 35-40 nm per minute with substrate temperatures of approximately 400°C.

The coating 30 may be applied to any suitable thickness between about 2 and about 4 µm. The thickness of the coating 30 on the base metal substrate should be such so as not to cause any adverse effects on the fatigue life of the metal base. The coating 30 should also be applied to a uniform thickness.

### EXAMPLE

An embodiment of the invention will be described by way of example, which is meant to be merely illustrative and therefore non limiting.

Aluminum nitride (AIN) was first deposited by cathodic arc deposition on a test substrate of René 88DT superalloy material to a thickness of about 3-4 µm. In this case, the coated sample was then pre-oxidized in air at about 1300°F (704°C) for 24 hours. Corrosion testing of the sample was conducted and the sample advantageously has exceeded 3 times the corrosion initiation life of the bare substrate without corrosion initiation. The cyclic corrosion testing included exposure at about 1300°F (704°C) for 1 hour hot time with a partially molten salt corrosive mix application. Moreover, the sample did not show any signs of discoloration or spallation. Although not necessarily required, the pre-oxidation cycle employed may allow the AIN coating to form a protective layer of alumina, which may further retard corrosion attack.

## Claims

1. A turbine engine rotor disk or seal element (10) consisting of:
a base metal substrate (32);
an oxidation and corrosion resistant overlay coating (30) applied directly on the base metal substrate of the turbine engine rotor disk or seal element to a thickness of 2-4 µm, the coating being aluminum nitride; and
an oxide metal layer over the overlay coating (30), comprising an oxide of the metal of the overlay coating.

2. A method of protecting a turbine engine rotor disk or seal element from oxidation and corrosion comprising:
providing a turbine engine rotor disk or seal element (10) having a base metal substrate (32);
applying an oxidation and corrosion resistant overlay coating (30) to a thickness of 2-4 µm directly on the base metal substrate, the overlay coating being aluminum nitride; and
exposing the applied overlay coating (30) to elevated temperature in air to form over the overlay coating an oxide of the metal of the overlayer coating.

## Patentansprüche

1. Turbinentriebwerks-Rotorscheibe oder -Dichtungselement (10), bestehend aus:
einem Basismetallsubstrat (32);
einer oxidations- und korrosionsbeständigen Überzugsbeschichtung (30), die direkt auf das Basismetallsubstrat (32) der(s) Turbinentriebwerks-Rotorscheibe oder -Dichtungselementes bis zu einer Dicke von 2 - 4 µm aufgebracht ist, wobei die Beschichtung aus Aluminiumnitrid besteht; und
einer Metalloxidschicht über der Überzugsbeschichtung (30), die ein Oxid des Metalls der Überzugsbeschichtung aufweist.

2. Verfahren zum Schützen einer(s) Turbinentriebwerks-Rotorscheibe oder -Dichtungselementes (10) vor Oxidation und Korrosion, mit den Schritten:
Bereitstellen einer(s) Turbinentriebwerks-Rotorscheibe oder -Dichtungselementes mit einem Basismetallsubstrat (32);
Aufbringen einer oxidations- und korrosionsbeständigen Überzugsbeschichtung (30) bis zu einer Dicke von 2 - 4 µm direkt auf das Basismetallsubstrat, wobei die Beschichtung aus Aluminiumnitrid besteht; und
Aussetzen der aufgebrachten Überzugsbeschichtung (30) an erhöhte Temperaturen in Luft, um über der Überzugsbeschichtung ein Oxid des Metalls der Überzugsbeschichtung auszubilden.

## Revendications

1. Disque ou élément d'étanchéité (10) de rotor de moteur à turbine, constitué de :
un substrat (32) en métal de base ;
un revêtement couvrant (30) résistant à l'oxydation et à la corrosion, appliqué directement sur une épaisseur de 2 à 4 µm sur le substrat en métal de base du disque ou élément d'étanchéité de rotor de moteur à turbine, le revêtement étant du nitrure d'aluminium ; et
une couche métallique d'oxyde par-dessus le revêtement couvrant (30), constituée par un oxyde du métal du revêtement couvrant.

2. Procédé de protection d'un disque ou élément d'étanchéité de rotor de moteur à turbine contre l'oxydation et la corrosion, comprenant :
la réalisation d'un disque ou élément d'étanchéité (10) de rotor de moteur à turbine ayant un substrat (32) en métal de base ;
l'application d'un revêtement couvrant (30) résistant à l'oxydation et à la corrosion sur une épaisseur de 2 à 4 µm directement sur le substrat en métal de base, le revêtement couvrant étant du nitrure d'aluminium ; et
l'exposition du revêtement couvrant appliqué (30) à une haute température dans l'air pour former par-dessus le revêtement couvrant un oxyde du métal du revêtement couvrant.
